# FASCICULE DE BREVET EUROPEEN

(11) **EP 3 005 408 B1**
(45) Date de publication et mention de la délivrance du brevet: **09.08.2017**
(21) Numéro de dépôt: 14726167.1
(22) Date de dépôt: 26.05.2014
(51) Int. Cl.: H01L 23/00, H01L 21/18

(54) **PROCÉDÉ D'ASSEMBLAGE DE DEUX SUBSTRATS DE NATURE DIFFÉRENTE VIA UNE COUCHE INTERMÉDIAIRE DUCTILE**
VERFAHREN ZUM ZUSAMMENFÜGEN VON ZWEI SUBSTRATEN VERSCHIEDENER BESCHAFFENHEIT MITHILFE EINER DUKTILEN ZWISCHENSCHICHT
METHOD FOR ASSEMBLING TWO SUBSTRATES OF DIFFERENT NATURES VIA A DUCTILE INTERMEDIATE LAYER

(30) Priorité: 27.05.2013 FR 1354743
(43) Date de publication de la demande: 13.04.2016
(73) Titulaire: Commissariat à l'Énergie Atomique et aux Énergies Alternatives, 75015 Paris (FR)
(72) Inventeur: IMBERT, Bruno, F-38000 Grenoble (FR); BENAISSA, Lamine, F-91300 Massy (FR); GONDCHARTON, Paul, F-38100 Grenoble (FR)
(74) Mandataire: Brevalex
(86) Numéro de dépôt international: PCT/EP2014/060789
(87) Numéro de publication internationale: WO 2014/191337

(56) Documents cités:
- EP-A2- 0 147 360
- US-A1- 2009 183 825
- ALEXE M ET AL: "Low temperature GaAs/Si direct wafer bonding", ELECTRONICS LETTERS, IEE STEVENAGE, GB, vol. 36, no. 7, 30 mars 2000 (2000-03-30), pages 677-678, XP006015060, ISSN: 0013-5194, DOI: 10.1049/EL:20000507

## Description

### DOMAINE TECHNIQUE

Le domaine de l'invention est celui de la réalisation de structures hétérogènes, dites hétérostructures, formées par collage d'un premier substrat et d'un deuxième substrat qui présentent des coefficients de dilatation thermique différents. De telles hétérostructures sont utilisées notamment en microélectronique ou en optoélectronique, en réponse par exemple à des problèmes tels que l'intégration 3D de composants, l'encapsulation de microsystèmes électromécaniques (MEMS pour *MicroElectroMechanical Systems*), ou encore le report de composants sur embases métalliques.

L'invention vise plus particulièrement à contrôler la déformation que de telles hétérostructures sont susceptibles de présenter à température ambiante lorsqu'elles ont été soumises à des recuits thermiques, de façon notamment à minimiser cette déformation.

### ÉTAT DE LA TECHNIQUE ANTÉRIEURE

Il est connu que les recuits appliqués à des assemblages de matériaux présentant des propriétés de dilatation thermique différentes conduisent à l'apparition d'une déformation macroscopique, notamment de type courbure de plaque, qui peut s'avérer incompatible avec les procédés de microélectronique ultérieurs sur ces assemblages (comme par exemple la fixation des plaques dans les chambres, les manipulations par les robots des machines, planéité des procédés de dépôt en face arrière, etc.).

Ainsi, le collage pour formation d'une hétérostructure a depuis longtemps été investigué dans les domaines de l'optoélectronique, avec par exemple le collage d'arséniure de gallium (AsGa) sur silicium (Si). L'article de M. Alexe et al. intitulé « Low temperature GaAs/Si direct wafer bonding", Electronics Letters, Vol.36, Issue 7, présente ainsi la réalisation d'une hétérostructure AsGa/Si par ajout d'une couche interfaciale de verre de silicate. Cet assemblage tient en température jusqu'à une température mesurée à 280°C, température au-delà de laquelle l'hétérostructure se rompt. Il est également montré dans cet article que l'augmentation du budget thermique appliqué à l'hétérostructure, outre le fait d'augmenter les contraintes à chaud, permet au final d'augmenter l'énergie de collage de l'hétérostructure.

La réalisation d'une hétérostructure formée de l'empilement phosphure d'indium (InP) sur arséniure de gallium (AsGa) est décrite dans l'article de Z. L. Liau et D. E. Mull, « Wafer fusion: A novel technique for optoelectronic device fabrication and monolithic integration », Applied Physics Letters, vol. 56, n° 8, p. 737-739, févr. 1990. Cette hétérostructure, réalisée par la méthode de collage direct assisté par thermocompression à des températures supérieures ou égale à 520 °C, présente toutefois une courbure. Si cet article ne donne pas de chiffrage précis de la courbure, la réalisation d'une simulation de l'évolution de la flèche d'une hétérostructure InP/AsGa en fonction de la température permet de montrer que pour un recuit au-delà de 500°C la flèche avoisine 1 mm pour des substrats de 100 mm de diamètre, soit un rayon de courbure de l'ordre de 1,25 mètre.

Le document US2009/183825 décrit un procédé de collage d'un premier substrat et d'un deuxième substrat par l'intermédiaire de films de collage, principalement constitués de cuivre. Le collage est effectué par thermocompression. Dans le cas de substrats présentant des coefficients de dilatation thermique différents, ce document propose des températures de collage faible (de 20 à 50°C). Le collage assisté par thermocompression cuivre-cuivre est également connu de l'homme du métier. L'article de K. N. Chen, Y. Zhu, W. W. Wu, et R. Reif, « Investigation and Effects of Wafer Bow in 3D Integration Bonding Schemes », Journal of Electronic Materials, vol. 39, no 12, p. 2605-2610, déc. 2010, fait ainsi état de ce que le collage de plaques de 200 mm de diamètre dont l'une présente une flèche est possible jusqu'à des valeurs de flèche de 100 µm. Cependant les collages obtenus par ce procédé présentent post-collage une flèche d'une valeur équivalente à celle de la plaque courbée.

Les techniques antérieures décrites notamment dans ces articles n'apportent donc pas de solution au problème d'apparition, lors des recuits des hétérostructures, d'une déformation macroscopique qui peut s'avérer incompatible avec la réalisation de procédés de microélectronique ultérieurs sur les hétérostructures.

### EXPOSÉ DE L'INVENTION

L'invention a pour but d'offrir une méthode d'assemblage peu onéreuse de deux substrats ayant des coefficients de dilatation thermique différents, qui puisse permettre de réaliser une hétérostructure à déformation contrôlée et notamment à déformation réduite, en particulier une hétérostructure présentant un rayon de courbure supérieur à 1,5 mètre et avantageusement supérieur à 80 mètres, compatible avec la réalisation de procédés de microélectronique ultérieurs sur l'assemblage.

L'invention propose à cet effet un procédé de fabrication d'une hétérostructure, comprenant les étapes de :
- mise en contact d'un premier substrat ayant un premier coefficient de dilatation thermique et d'un deuxième substrat ayant un deuxième coefficient de dilatation thermique différent dudit premier coefficient de dilatation thermique,
- recuit de l'assemblage formé par la mise en contact du premier substrat et du deuxième substrat,
- après recuit, retour à température ambiante dudit assemblage,
caractérisé par :
- la fourniture, avant ladite mise en contact, d'au moins une couche intermédiaire en surface d'au moins un des premier et deuxième substrats, ladite au moins une couche intermédiaire étant réalisée en un matériau ductile lors des étapes de recuit et de retour à température ambiante,
- la réalisation de la mise en contact avec l'au moins une couche intermédiaire intercalée entre le premier et le deuxième substrats,
- lors du retour à température ambiante, l'application d'une pression extérieure audit assemblage afin de compresser ledit assemblage.

Certains aspects préférés mais non limitatifs de procédé sont les suivants :
- le recuit est mis en oeuvre lors d'un collage assisté par thermocompression du premier et du deuxième substrats mis en contact avec l'au moins une couche intermédiaire intercalée entre eux ;
- la mise en contact est un collage direct (non thermocompressif) du premier et du deuxième substrat avec l'au moins une couche intermédiaire intercalée entre eux, et le recuit est un recuit de renforcement du collage ;
- il comprend en outre une compression dudit assemblage mise en oeuvre pendant une partie au moins dudit recuit de renforcement du collage ;
- lors du retour à température ambiante, l'assemblage est compressé par application d'une pression uniaxiale extérieure ;
- la pression uniaxiale est sensiblement uniforme sur l'ensemble de l'assemblage de sorte que l'assemblage est maintenu avec un rayon de courbure supérieur à 10m et avantageusement supérieur à 80m ;
- on procède avant mise en contact du premier et du deuxième substrat à un amollissement de ladite au moins une couche intermédiaire pour en diminuer la limite élastique ;
- l'amollissement réalisé par recuit thermique, ou par modification de la microstructure de l'au moins une couche intermédiaire ;
- il comprend, avant la mise en contact, la formation, par implantation d'espèces atomiques, d'une zone de fragilisation à l'intérieur du premier substrat, et, après mise en contact, l'amincissement du premier substrat par séparation dudit premier substrat au niveau de la zone de fragilisation ;
- le premier et le deuxième substrats sont en des matériaux qui se trouvent dans leur régime de déformation élastique lors des étapes de recuit et de retour à température ambiante ;
- l'au moins une couche intermédiaire est une couche déposée sur la surface d'au moins un des premier et deuxième substrats ;
- le premier substrat est un substrat de silicium, le deuxième substrat est un substrat de phosphure d'indium, et l'au moins une couche intermédiaire est une couche de cuivre ;
- l'au moins une couche intermédiaire est une couche superficielle du deuxième substrat ;
- le premier substrat est un substrat de silicium et le deuxième substrat est un substrat de cuivre.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
- les figures 1a-1e illustrent une première variante d'un mode de réalisation possible du procédé selon l'invention ;
- la figure 2 illustre l'évolution temporelle de la température et de la pression appliquées à l'hétérostructure dans le cadre de la première variante des figures 1a-1e;
- les figures 3a-3f illustrent une deuxième variante d'un mode de réalisation possible du procédé selon l'invention ;
- la figure 4 illustre l'évolution temporelle de la température et de la pression appliquées à l'hétérostructure dans le cadre de la deuxième variante des figures 3a-3f.

### EXPOSÉ DÉTAILLÉ DE MODES DE RÉALISATION PARTICULIERS

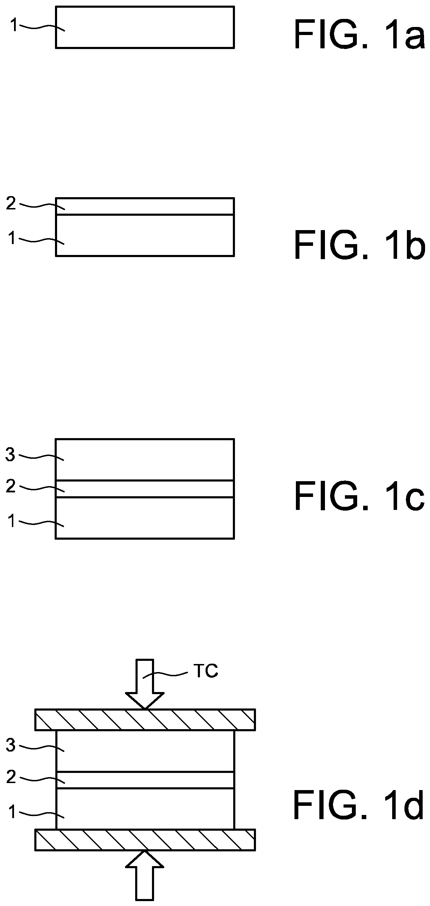

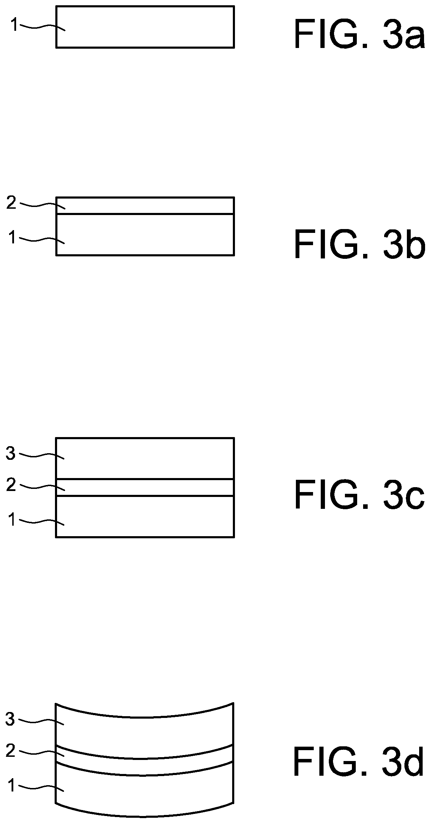

En référence aux figures 1a-1e et aux figures 3a-3f, l'invention concerne un procédé de fabrication d'une hétérostructure H comprenant au moins une couche intermédiaire 2 intercalée entre un premier substrat 1 ayant un premier coefficient de dilatation thermique et un deuxième substrat 3 ayant un deuxième coefficient de dilatation thermique différent dudit premier coefficient de dilatation thermique au moins dans l'une des orientations des substrats, typiquement d'au moins 10% ou 20% à température ambiante. Une telle différence induit des contraintes au sein de l'hétérostructure lorsque celle-ci subit un traitement thermique.

A titre d'exemple illustratif, à température ambiante (20°C), le coefficient de dilatation n thermique du silicium est de 3.10⁻⁶C⁻¹ tandis que celui du phosphure d'indium est de 4,6.10⁻⁶C⁻¹.

Partant comme représenté sur les figures 1a et 3a d'un premier substrat 1, le procédé comporte une première étape de fourniture d'au moins une couche intermédiaire en surface d'au moins un des premier et deuxième substrats. Sur les figures 1b et 3b, on a représenté la fourniture d'une couche intermédiaire 2 en surface du premier substrat 1.

La couche intermédiaire 2 peut être une couche déposée sur l'un et/ou l'autre des substrats 1, 3. La couche intermédiaire 2 peut être une couche superficielle de l'un des substrats.

A titre d'exemple illustratif, la couche intermédiaire 2 est une couche de cuivre d'épaisseur comprise entre 50 nm et 10 µm déposée sur l'un et/ou l'autre des substrats 1, 3.

Dans un mode de réalisation, une couche barrière peut être interposée entre l'un des substrats et la couche intermédiaire fournie en surface dudit substrat en vue de contrecarrer la diffusion du matériau de la couche intermédiaire dans le substrat en particulier lors des étapes ultérieures de traitement thermique. A titre d'exemple illustratif, une couche barrière en nitrure de titane ou en nitrure de tantale peut être interposée entre un substrat de silicium et une couche intermédiaire de cuivre pour prévenir la diffusion du cuivre dans le silicium.

La couche intermédiaire 2 présente des propriétés thermomécaniques particulières comme cela sera détaillé par la suite.

En référence aux figure 1c et 3c, le procédé comporte ensuite une étape de mise en contact des premier et deuxième substrats réalisée de manière à ce que l'au moins une couche intermédiaire soit intercalée entre le premier et le deuxième substrat.

Le premier substrat et le deuxième substrat mis en contact à température ambiante sont ensuite soumis à un recuit (recuit de collage ou recuit de renforcement du collage comme cela sera exemplifié par la suite), avant que l'assemblage obtenu après le recuit soit ramené à température ambiante.

Dans le cadre de l'invention, ledit assemblage est maintenu sous pression par application d'une pression externe, par exemple par application d'une pression uniaxiale externe pleine plaque ou localisée, lors du retour à température ambiante. Ceci permet de maintenir la planéité (rayon de courbure typiquement supérieur à 10 m, voire à 80m) durant la descente en température, d'induire une déformation plastique de la couche intermédiaire et ainsi de limiter la flèche de l'hétérostructure à température ambiante. L'invention n'est toutefois pas limitée à un tel maintien de la planéité mais s'étend également à un maintien sous pression par application d'une pression extérieure lors du retour à température ambiante réalisé de manière à conférer un rayon de courbure donné à l'hétérostructure, typiquement au moyen d'une presse dont la surface en contact avec l'hétérostructure n'est pas plane mais courbée à cet effet.

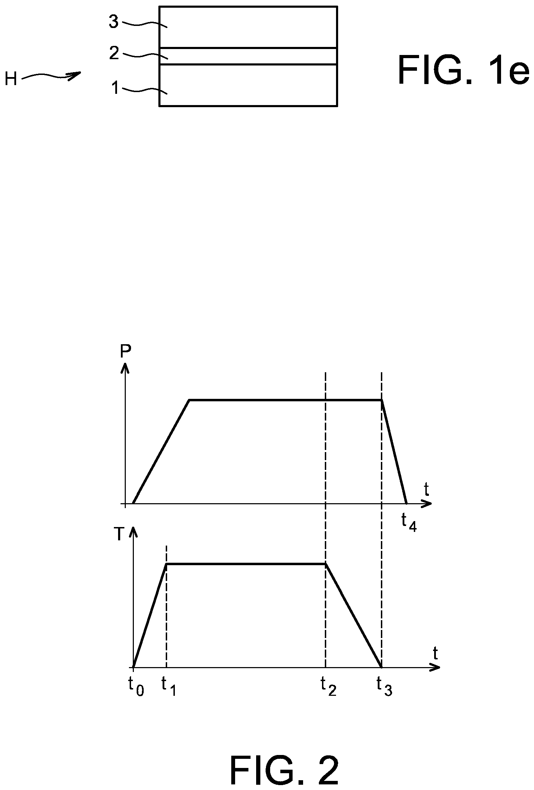

Dans une première variante de réalisation illustrée par les figures 1a-1e et par la figure 2, les substrats mis en contact n'adhèrent pas l'un à l'autre à température ambiante, par exemple en l'absence d'opérations de préparation de surface des substrats avant leur mise en contact. En référence à la figure 1d, on vient alors procéder à un collage assisté par thermocompression TC des substrats mis en contact, le recuit susmentionné étant dès lors réalisé au cours de la thermocompression. Comme représenté sur la figure 2, le recuit T peut être réalisé entre 30°C et 400°C sur une durée typiquement supérieure à 30 minutes pour un recuit autour de 200°C (fonction des matériaux en présence). Le recuit T peut être réalisé à température constante sur une période t1-t2, avec une phase préalable de montée en température depuis la température ambiante sur une période t0-t1, et une phase ultérieure de redescente en température sur une période t2-t3. Comme indiqué précédemment, l'assemblage obtenu à l'issue du recuit est compressé lors du retour à température ambiante, par exemple par application d'une pression uniaxiale sensiblement uniforme sur les substrats assemblés comprise entre 0,1 et 7,64 MPa, notamment en utilisant le même appareil que celui utilisé pour réaliser le collage assisté par thermocompression. La pression P appliquée aux substrats mis en contact est ainsi non seulement appliquée pour la réalisation du collage assisté par thermocompression, mais également appliquée lors du retour à température ambiante sur la période t2-t3. Ce n'est qu'après t3 que la pression est relâchée. En référence à la figure 1e, on aboutit à l'hétérostructure H recherchée à flèche quasi-nulle. Dans le cadre de cette première variante, on peut avantageusement recourir à la fourniture d'une couche intermédiaire sur chacun des substrats 1, 3, ce qui facilite le collage assisté par thermocompression.

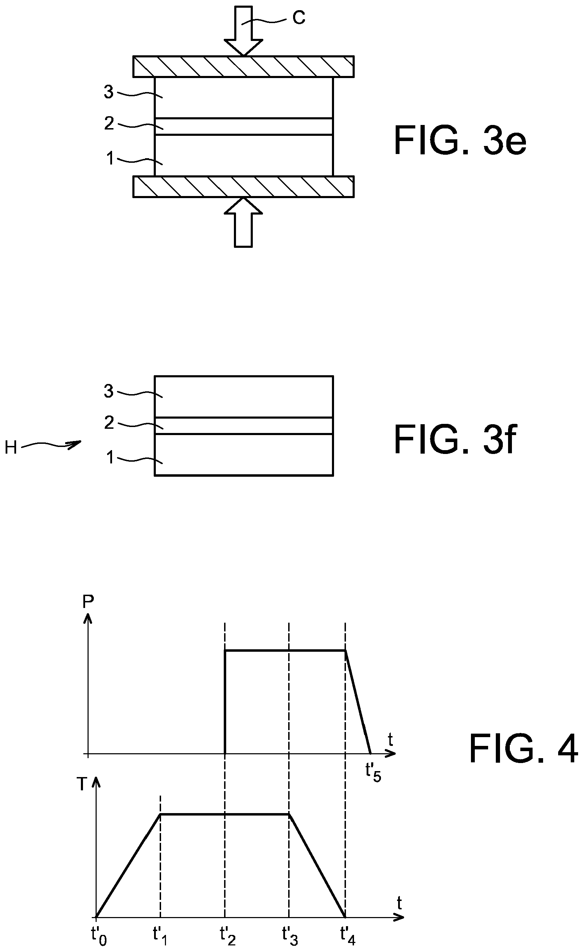

Dans une deuxième variante de réalisation illustrée par les figures 3a-3f et par la figure 4, les substrats mis en contact adhèrent l'un à l'autre (collage direct non thermocompressif) à température ambiante, par exemple du fait d'opérations de préparation de surface des substrats réalisés avant leur mise en contact. L'énergie de collage est toutefois relativement faible et incompatible avec les besoins de l'application finale en termes de tenue mécanique notamment de sorte qu'un recuit de renforcement du collage doit être appliqué aux substrats ainsi collés. Comme représenté sur la figure 4, ce recuit T peut être réalisé à température constante sur une période t'1-t'3, par exemple autour de 200°C pendant 30 minutes, avec une phase préalable de montée en température depuis la température ambiante sur une période t'0-t'1, et une phase ultérieure de redescente en température sur une période t'3-t'4. Comme indiqué précédemment, et comme représenté sur la figure 3e, l'assemblage obtenu à l'issue du recuit est compressé lors du retour à température ambiante sur la période t'3-t'4 par application d'une pression P.

Comme représenté sur la figure 3d, la réalisation du recuit de renforcement du collage va engendrer une déformation de l'hétérostructure, déformation qui provoque classiquement la rupture de l'hétérostructure lors de la remise à température ambiante. Le maintien sous pression pendant la remise à température ambiante par application d'une pression extérieure et le choix de la couche intermédiaire ductile permettent comme représenté sur la figure 3f d'obtenir l'hétérostructure H recherchée à flèche quasi-nulle.

Dans le cadre de cette deuxième variante, le recuit peut être réalisé avec un budget thermique supérieur (par exemple sur une période t'1-t'3 plutôt que sur une période t'1-t'2 comme illustré par le figure 4) à un budget qui conduit à la rupture de l'hétérostructure lorsque celle-ci est réalisée suivant un procédé de collage direct standard. Et la compression P peut être appliquée non seulement lors de la redescente en température, mais également lors d'une partie au moins du recuit, comme c'est le cas sur la période t'2-t'3 sur la figure 4.

Ainsi le recuit du procédé selon l'invention peut être réalisé lors d'une thermocompression. Il peut alternativement prendre la forme d'un recuit en four conventionnel, tel qu'un recuit mis en oeuvre suivant un collage direct conventionnel.

Dans le cadre de l'invention, on a recours à une couche intermédiaire réalisée en un matériau présentant des propriétés thermomécaniques telles que les efforts de déformation de l'assemblage, induits par les contraintes générées par la différence de coefficient de dilatation thermique des premier et deuxième substrat et par la mise sous pression de l'assemblage lors du retour à température ambiante, peuvent être absorbés par ladite couche intermédiaire. La couche intermédiaire subit pour cela une déformation plastique qui permet de dissiper lesdits efforts de déformation, par exemple par génération de défauts structuraux dans ladite couche intermédiaire.

A titre d'exemple illustratif, la couche intermédiaire est une couche métallique, par exemple une couche d'aluminium, d'or, d'argent, de titane ou de cuivre. On pourra à cet égard se référer à l'article de M. Hommel et O. Kraft, « Deformation behavior of thin copper films on deformable substrates », Acta Materialia, vol. 49, no 19, p. 3935-3947, nov. 2001, dans lequel il a été montré que des couches minces de cuivre (entre 0,2 et 5 µm) sont capables d'emmagasiner des contraintes importantes par déformation plastique. Le cuivre en effet, lorsqu'il est sous forme de couches minces polycristallines, est capable d'entrer dans son domaine plastique sous de très faibles contraintes appliquées. Il va ensuite « stocker » les efforts en tension ou compression par création de dislocations dans ces grains.

La couche intermédiaire est ainsi réalisée en un matériau qui est ductile lors des étapes de recuit et de retour à température ambiante. Pour la contrainte exercée lors de ces étapes, la couche intermédiaire est ainsi dans son régime de déformation plastique (régime de déformation irréversible ne conduisant pas la rupture du matériau). La contrainte Cᵣₘ pour laquelle sa limite mécanique à la rupture est atteinte est ainsi supérieure à la contrainte Cᵢ induite par la différence entre les coefficients de dilatation thermique des premier et deuxième substrats et par le maintien sous pression de l'assemblage lors du retour à température ambiante. La contrainte Ce pour laquelle sa limite élastique est atteinte est quant à elle inférieure à ladite contrainte induite Cᵢ.

L'épaisseur de la couche intermédiaire est avantageusement choisie pour que celle-ci puisse absorber ladite contrainte induite Cᵢ, la couche étant typiquement d'autant plus épaisse que la contrainte induite est importante.

De manière préférentielle, le premier et le deuxième substrat sont en des matériaux qui se trouvent dans leur régime de déformation élastique au cours des étapes du procédé. En d'autres termes, la contrainte induite Cᵢ exercée sur l'assemblage est inférieure à la contrainte pour laquelle la limite élastique est atteinte pour chacun des premier et deuxième substrats.

On rappelle que la limite élastique d'un matériau peut être déterminée par mesure de nanoindentation qui permet l'accès à la valeur de la dureté du matériau et ainsi à la valeur de sa limite élastique par la formule de Tabor.

Dans un mode de réalisation de l'invention, on a recours à une couche intermédiaire sous la forme d'une couche mince dont la limite mécanique à la rupture peut être assimilée à un point quasi infini, comme par exemple une couche de cuivre d'épaisseur inférieure à 10µm.

Le maintien sous pression de l'assemblage durant la descente en température vers la température ambiante conduit la couche intermédiaire à transférer les contraintes dues aux différences de coefficients de dilatation thermique (observables par la création d'une flèche dans les procédés classiques) en contraintes intrinsèques quantifiables par la création de défauts cristallins type lacunes, dislocations, etc. dans la microstructure de la couche intermédiaire (écrouissage de la couche comme observé en métallurgie). La couche intermédiaire doit ainsi présenter une épaisseur supérieure à une épaisseur minimale où elle ne peut entrer dans un régime de déformation plastique en acceptant la formation de défauts cristallins. A titre d'exemple, cette épaisseur minimale est de l'ordre de 50 nm pour le cuivre.

L'invention permet ainsi de réaliser un collage à chaud de deux substrats différents à une température où classiquement la remise à température ambiante provoque la rupture de l'assemblage obtenu après collage. L'invention permet par ailleurs d'intégrer dans un procédé de fabrication d'une hétérostructure une étape de recuit post collage qui permet une meilleure adhérence du collage réalisé, et en particulier un recuit qui peut être réalisé pour des budgets thermiques qui conduisent classiquement à la rupture de l'hétérostructure ou à la formation d'une flèche résiduelle lorsque l'hétérostructure est réalisée suivant un procédé de collage direct standard.

Dans un mode de réalisation, on vient amollir la couche intermédiaire (en d'autres termes, réduire sa dureté) avant la mise en contact des substrats afin d'en diminuer la limite élastique et ainsi améliorer sa capacité d'absorption des déformations plastiques. Cet amollissement de la couche intermédiaire peut être réalisé par recuit thermique. Il peut également consister à modifier la microstructure de la couche intermédiaire, notamment par augmentation de la taille des grains.

Dans un mode de réalisation, le procédé selon l'invention comprend, avant la mise en contact des substrats, la formation par implantation d'espèces atomiques d'une zone de fragilisation à l'intérieur du premier substrat, et l'amincissement, après la mise en contact, du premier substrat par séparation dudit premier substrat au niveau de la zone de fragilisation. En mettant ainsi en oeuvre la technologie Smart Cut™ dans le cadre du procédé selon l'invention, on peut réaliser le report successif d'une couche sur un autre substrat malgré des coefficients de dilatation thermique différents.

Des exemples de réalisation de l'invention sont les suivants. Dans un premier exemple, on forme une hétérostructure InP/Si avec une couche intermédiaire de cuivre sur chacun des substrats. Après collage assisté par thermocompression à une température de 250°C et une pression de de 3.82MPa pendant 1h, l'assemblage obtenu après collage présente une flèche de 200 µm (pour des substrats de 100 mm). En mettant en oeuvre l'invention via un maintien, pendant la redescente en température, de l'assemblage sous pression de 3,82 MPa, on obtient une flèche quasi nulle de l'ordre de 6 µm.

Dans un second exemple, on forme une hétérostructure Cu/Si. Après collage assisté par thermocompression à une température de 250°C et une pression de 3.82MPa pendant 1h, l'assemblage obtenu après collage présente une flèche de 1100 µm (pour des substrats de 100 mm de diamètre). Si l'assemblage ne casse pas, les substrats suivent la courbure, ce qu'une lente redescente en température de 1°C/min ne permet pas de limiter. En mettant en oeuvre l'invention avec une couche intermédiaire prenant la forme d'une couche superficielle du substrat cuivre, une autre couche intermédiaire de cuivre en surface du substrat de silicium et maintien pendant la redescente en température post-collage de l'assemblage sous pression de 6,37 MPa, la flèche se retrouve diminuée de 300 µm. On obtient donc un rayon de courbure de l'ordre de 1,6m.

Le tableau ci-dessous fournit différents exemples d'hétérostructures pouvant être fabriquées par le procédé selon l'invention au moyen de substrats présentant des coefficients de dilatation thermique différents.

| | Si | Saphir | quartz | Ge | LiNbO3 | LiTaO5 | GaAs | SiC | Si polycristallin | InP |
|---|---|---|---|---|---|---|---|---|---|---|
| Si | | ok | ok | ok | ok | ok | Ok | ok | ok | ok |
| Saphir | | | | ok | ok | ok | Ok | ok | ok | ok |
| quartz | | | | ok | ok | ok | Ok | ok | ok | ok |
| Ge | | | | | ok | ok | Ok | ok | ok | ok |
| LiNbO3 | | | | | | ok | Ok | ok | ok | ok |
| LiTaO5 | | | | | | | Ok | ok | ok | ok |
| GaAs | | | | | | | | ok | ok | ok |
| SiC | | | | | | | | | ok | ok |
| Si polycristallin | | | | | | | | | | ok |

## Revendications

1. Procédé de fabrication d'une hétérostructure (H), comprenant les étapes de :
- mise en contact d'un premier substrat (1) ayant un premier coefficient de dilatation thermique et d'un deuxième substrat (3) ayant un deuxième coefficient de dilatation thermique différent dudit premier coefficient de dilatation thermique,
- recuit de l'assemblage formé par la mise en contact du premier substrat et du deuxième substrat,
- après recuit, retour à température ambiante dudit assemblage,
- la fourniture, avant ladite mise en contact, d'au moins une couche intermédiaire (2) en surface d'au moins un des premier et deuxième substrats, ladite au moins une couche intermédiaire étant réalisée en un matériau ductile lors des étapes de recuit et de retour à température ambiante,
- la réalisation de la mise en contact avec l'au moins une couche intermédiaire intercalée entre le premier et le deuxième substrat,
**caractérisé en ce que** :
- lors du retour à température ambiante, l'application d'une pression extérieure audit assemblage afin de compresser (TC, C) ledit assemblage.

2. Procédé selon la revendication 1, dans lequel le recuit est mis en oeuvre lors d'un collage assisté par thermocompression (TC) du premier et du deuxième substrat mis en contact avec l'au moins une couche intermédiaire intercalée entre eux.

3. Procédé selon la revendication 1, dans lequel la mise en contact est un collage direct du premier et du deuxième substrats avec l'au moins une couche intermédiaire intercalée entre eux, et dans lequel le recuit est un recuit de renforcement du collage.

4. Procédé selon la revendication 3, comprenant en outre une compression (C) dudit assemblage mise en oeuvre pendant une partie au moins dudit recuit de renforcement du collage.

5. Procédé selon l'une des revendications 1 à 4, dans lequel lors du retour à température ambiante dudit assemblage, la pression extérieure appliquée audit assemblage est une pression uniaxiale.

6. Procédé selon l'une des revendications 1 à 4, dans lequel lors du retour à température ambiante, le rayon de courbure dudit assemblage est maintenu supérieur à 10 mètres, de préférence supérieur à 80 mètres.

7. Procédé selon l'une des revendications 1 à 6, dans lequel on procède avant mise en contact du premier et du deuxième substrat à un amollissement de ladite au moins une couche intermédiaire pour en diminuer la limite élastique.

8. Procédé selon la revendication 7, dans lequel l'amollissement de ladite au moins une couche intermédiaire est réalisé par recuit thermique.

9. Procédé selon la revendication 7, dans lequel l'amollissement de ladite au moins une couche intermédiaire est réalisé par modification de sa microstructure.

10. Procédé selon l'une des revendications 1 à 9, comprenant, avant la mise en contact, la formation, par implantation d'espèces atomiques, d'une zone de fragilisation à l'intérieur du premier substrat, et, après mise en contact, l'amincissement du premier substrat par séparation dudit premier substrat au niveau de la zone de fragilisation.

11. Procédé selon l'une des revendications 1 à 10, dans lequel le premier et le deuxième substrat sont en des matériaux qui se trouvent dans leur régime de déformation élastique lors des étapes de recuit et de retour à température ambiante.

12. Procédé selon l'une des revendications 1 à 11, dans lequel l'au moins une couche intermédiaire est une couche déposée sur la surface d'au moins un des premier et deuxième substrats.

13. Procédé selon la revendication 12, dans lequel le premier substrat est un substrat de silicium, le deuxième substrat est un substrat de phosphure d'indium, et l'au moins une couche intermédiaire est une couche de cuivre.

14. Procédé selon l'une des revendications 1 à 11, dans lequel l'au moins une couche intermédiaire est une couche superficielle du deuxième substrat.

15. Procédé selon la revendication 14, dans lequel le premier substrat est un substrat de silicium et le deuxième substrat est un substrat de cuivre.

## Patentansprüche

1. Verfahren zum Herstellen einer Heterostruktur (H), umfassend die nachfolgenden Schritte:
- Inkontaktbringen eines ersten Substrats (1) mit einem ersten Wärmeausdehnungskoeffizienten und eines zweiten Substrats (3) mit einem zweiten Wärmeausdehnungskoeffizienten, der sich vom ersten Wärmeausdehnungskoeffizienten unterscheidet,
- Tempern der durch Inkontaktbringen von erstem Substrat und zweitem Substrat gebildeten Zusammenfügung,
- nach dem Tempern Rückführen der Zusammenfügung auf Raumtemperatur,
- vor dem Inkontaktbringen Bereitstellen zumindest einer Zwischenschicht (2) an der Oberfläche von zumindest einem aus erstem und zweitem Substrat, wobei die zumindest eine Zwischenschicht aus einem duktilen Material während der Schritte des Temperns und Rückführens auf Raumtemperatur hergestellt wird,
- Durchführen der Kontaktierung mit der zumindest einen Zwischenschicht, die zwischen dem ersten und dem zweiten Substrat eingefügt ist,
**dadurch gekennzeichnet, dass**
- beim Rückführen auf Raumtemperatur das Aufbringen eines Außendrucks auf die Zusammenfügung erfolgt, um die Zusammenfügung zusammenzudrücken (TC, C).

2. Verfahren nach Anspruch 1, wobei das Tempern bei einem Bonden unter Thermokompression (TC) des ersten und des zweiten Substrats erfolgt, die mit der zumindest einen zwischen diesen eingefügten Zwischenschicht in Kontakt gebracht sind.

3. Verfahren nach Anspruch 1, wobei das Inkontaktbringen ein direktes Bonden des ersten und des zweiten Substrats mit der zumindest einen zwischen diesen eingefügten Zwischenschicht ist und wobei das Tempern ein Tempern zum Verstärken des Bondens ist.

4. Verfahren nach Anspruch 3, ferner umfassend ein Zusammendrücken (C) der Zusammenfügung, das zumindest während eines Teils des Temperns zum Verstärken des Bondens erfolgt.

5. Verfahren nach einem der Ansprüche 1 bis 4, wobei beim Rückführen der Zusammenfügung auf Raumtemperatur der auf die Zusammenfügung aufgebrachte Außendruck ein uniaxialer Druck ist.

6. Verfahren nach einem der Ansprüche 1 bis 4, wobei beim Rückführen auf Raumtemperatur der Krümmungsradius der Zusammenfügung auf über 10 m, vorzugsweise auf über 80 m, gehalten wird.

7. Verfahren nach einem der Ansprüche 1 bis 6, wobei vor dem Inkontaktbringen von erstem und zweitem Substrat ein Erweichen der zumindest einen Zwischenschicht erfolgt, um deren Elastizitätsgrenze zu vermindern.

8. Verfahren nach Anspruch 7, wobei das Erweichen der zumindest einen Zwischenschicht durch thermisches Tempern erfolgt.

9. Verfahren nach Anspruch 7, wobei das Erweichen der zumindest einen Zwischenschicht durch Verändern ihres Mikrogefüges erfolgt.

10. Verfahren nach einem der Ansprüche 1 bis 9, umfassend vor dem Inkontaktbringen das Ausbilden eines Versprödungsbereichs innerhalb des ersten Substrats durch Implantieren von atomaren Spezies und nach dem Inkontaktbringen das Einschnüren des ersten Substrats durch Abtrennen des ersten Substrats in Höhe des Versprödungsbereichs.

11. Verfahren nach einem der Ansprüche 1 bis 10, wobei das erste und das zweite Substrat aus Materialien bestehen, die sich während der Schritte des Temperns und des Rückführens auf Raumtemperatur in ihrer elastischen Verformungsphase befinden.

12. Verfahren nach einem der Ansprüche 1 bis 11, wobei die zumindest eine Zwischenschicht eine auf die Oberfläche von zumindest einem aus erstem und zweitem Substrat aufgebrachte Schicht ist.

13. Verfahren nach Anspruch 12, wobei das erste Substrat ein Siliciumsubstrat ist, das zweite Substrat ein Indiumphosphidsubstrat ist und die zumindest eine Zwischenschicht eine Kupferschicht ist.

14. Verfahren nach einem der Ansprüche 1 bis 11, wobei die zumindest eine Zwischensicht eine Oberflächenschicht des zweiten Substrats ist.

15. Verfahren nach Anspruch 14, wobei das erste Substrat ein Siliciumsubstrat und das zweite Substrat ein Kupfersubstrat ist.

## Claims

1. A method for manufacturing a heterostructure (H), comprising the steps of:
- contacting a first substrate (1) having a first coefficient of thermal expansion and a second substrate (3) having a second coefficient of thermal expansion different from the first coefficient of thermal expansion,
- annealing the assembly formed by contacting the first substrate and the second substrate,
- after annealing, returning said assembly to room temperature,
- providing, before said contacting, at least one intermediate layer (2) at the surface of at least one of the first and second substrates, said at least one intermediate layer being made of a material which is ductile during the steps of annealing and returning to room temperature,
- performing the contacting with the at least one intermediate layer sandwiched between the first and the second substrate,
**characterized in that**:
- upon returning to room temperature, applying an outer pressure to said assembly in order to compress (TC, C) said assembly.

2. The method according to claim 1, wherein the annealing is implemented during a thermal compression (TC)-aided bonding of the first and second substrates contacted with the at least one intermediate layer sandwiched between them.

3. The method according to claim 1, wherein the contacting is a direct bonding of the first and second substrates with the at least one intermediate layer sandwiched between them, and wherein the annealing is a bonding strengthening annealing.

4. The method according to claim 3, further comprising a compression (C) of said assembly implemented during at least a part of said bonding strengthening annealing.

5. The method according to one of claims 1 to 4, wherein upon returning said assembly to room temperature, the outer pressure applied to said assembly is a uniaxial pressure.

6. The method according to one of claims 1 to 4, wherein upon returning to room temperature, the radius of curvature of said assembly is maintained greater than 10 metres, preferably greater than 80 metres.

7. The method according to one of claims 1 to 6, wherein before contacting the first and second substrates, a softening of said at least one intermediate layer is performed to reduce the yield strength thereof.

8. The method according to claim 7, wherein softening said at least one intermediate layer is performed by thermal annealing.

9. The method according to claim 7, wherein softening said at least one intermediate layer is performed by modifying its microstructure.

10. The method according to one of claims 1 to 9, comprising, before the contacting, forming, by implanting atomic species, an embrittlement area inside the first substrate, and after the contacting, thinning the first substrate by separation of said first substrate at the embrittlement area.

11. The method according to one of claims 1 to 10, wherein the first and second substrates are made of materials which are in their state of elastic deformation during the steps of annealing and returning to room temperature.

12. The method according to one of claims 1 to 11, wherein the at least one intermediate layer is a layer deposited on the surface of at least one of the first and second substrates.

13. The method according to claim 12, wherein the first substrate is a silicon substrate, the second substrate is an indium phosphide substrate, and the at least one intermediate layer is a copper layer.

14. The method according to one of claims 1 to 11, wherein the at least one intermediate layer is a surface layer of the second substrate.

15. The method according to claim 14, wherein the first substrate is a silicon substrate, and the second substrate is a copper substrate.
